(19) Europäisches Patentamt
European Patent Office
Office européen des brevets

(11) EP 4 597 124 A1

(12) EUROPEAN PATENT APPLICATION

(43) Date of publication:
06.08.2025 Bulletin 2025/32

(21) Application number: 25153410.3

(22) Date of filing: 22.01.2025

(51) International Patent Classification (IPC):
G01R 27/02 (2006.01)     G01R 27/18 (2006.01)
G01R 31/42 (2006.01)     G01R 31/52 (2020.01)
H02M 7/5387 (2007.01)

(52) Cooperative Patent Classification (CPC):
G01R 31/52; G01R 27/02; G01R 27/025;
G01R 27/18; G01R 31/42; H02M 7/5387;
H02M 7/53875

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 30.01.2024 CN 202410131822

(71) Applicant: Sungrow (Shanghai) Co., Ltd.
Shanghai 201203 (CN)

(72) Inventors:
• LIU, Zhili
Hefei, Anhui, 230088 (CN)
• WU, Yaqi
Hefei, Anhui, 230088 (CN)
• LI, Jiaoli
Hefei, Anhui, 230088 (CN)
• GE, Yeming
Hefei, Anhui, 230088 (CN)

(74) Representative: Biallo, Dario et al
Barzanò & Zanardo S.p.A.
Via Borgonuovo, 10
20121 Milano (IT)

(54) **INVERTER AND INSULATION IMPEDANCE DETECTION METHOD FOR INVERTER**

(57) An inverter and an insulation impedance detection method for the inverter are provided. The insulation impedance detection method includes connecting a bridge arm midpoint of one phase at an AC side of an inverter circuit in the inverter to one electrode of the DC bus, and determining a relationship between a neutral-to-ground voltage at the AC side of the inverter circuit and a half-bus acquisition voltage of the DC bus under a present connection condition; and calculating the half-bus voltage before and after the controllable switch is turned on based on a sampled value of the neutral-to-ground voltage at the AC side and the relationship to obtain calculated values; and calculating an insulation impedance at the DC side of the inverter to ground based on the calculated values, equivalent impedances of the DC bus to the ground before and after the controllable switch is turned on.

FIG. 8

## Description

### FIELD

The present disclosure relates to the technical field of insulation detection, and in particular to an inverter and an insulation impedance detection method for the inverter.

### BACKGROUND

Generally, insulation impedance detection is performed on a photovoltaic string connected to a direct-current (DC) side of an inverter. Currently, a resistive bridge method is usually used. In the method, a Y-type resistive bridge is arranged, a switch is connected between two terminals of a resistor string connected to a positive electrode of a DC bus of the inverter in the Y-type resistive bridge. An insulation impedance of the photovoltaic string connected to the DC side of the inverter to ground is calculated by sampling voltages of the positive electrode of the DC bus to ground before and after the switch is turned on.

However, if the voltage of positive electrode of the DC bus to the ground is relatively low, a small sampled voltage deviates from an actual voltage, resulting in a low detection precision of the insulation impedance, and failing to meet an actual use requirement.

### SUMMARY

In view of this, an inverter and an insulation impedance detection method for the inverter are provided in the present disclosure, to solve the problem of a low detection accuracy of insulation impedance due to the relatively low voltage of the positive electrode of the DC bus to the ground.

In order to achieve the foregoing objective, the following technical solutions are provided according to the present disclosure.

In a first aspect, an insulation impedance detection method for an inverter is provided in the present disclosure. A direct-current, DC, bus of the inverter is grounded through a Y-type resistive bridge, and a controllable switch is connected between one electrode of the DC bus and a midpoint of the Y-type resistive bridge, and the insulation impedance detection method includes: connecting a bridge arm midpoint of one phase at an alternating-current, AC, side of an inverter circuit in the inverter to one electrode of the DC bus, and determining a relationship between a neutral-to-ground voltage at the AC side of the inverter circuit and a half-bus acquisition voltage of the DC bus under a present connection condition; calculating the half-bus acquisition voltage before and after the controllable switch is turned on based on a sampled value of the neutral-to-ground voltage at the AC side and the relationship to obtain calculated values; and calculating an insulation impedance at the DC side of the inverter to ground based on the calculated values of the half-bus acquisition voltage, an equivalent impedance of the DC bus to the ground before the controllable switch is turned on and an equivalent impedance of the DC bus to the ground after the controllable switch is turned on.

In an embodiment, the connecting a bridge arm midpoint of one phase at an AC side of an inverter circuit in the inverter to one electrode of the DC bus includes one of connecting the bridge arm midpoint of one phase at the AC side of the inverter circuit to a negative electrode of the DC bus; and connecting the bridge arm midpoint of one phase at the AC side of the inverter circuit to a positive electrode of the DC bus.

In an embodiment, the inverter circuit is a single-phase inverter circuit, and the bridge arm midpoint of one phase at the AC side of the inverter circuit is a live wire at the AC side of the inverter circuit, or a neutral wire at the AC side of the inverter circuit; or, the inverter circuit is a three-phase inverter circuit, and the bridge arm midpoint of one phase at the AC side of the inverter circuit is an R-phase bridge arm midpoint at the AC side of the inverter circuit, an S-phase bridge arm midpoint at the AC side of the inverter circuit, or a T-phase bridge arm midpoint at the AC side of the inverter circuit.

In an embodiment, the half-bus acquisition voltage is a positive half-bus voltage. The bridge arm midpoint of one phase at the AC side of the inverter circuit is connected to a negative electrode of the DC bus, and the relationship is that a difference obtained by subtracting the positive half-bus voltage from a DC bus voltage is equal to an absolute value of a sum of the neutral-to-ground voltage at the AC side and a voltage of the phase at the AC side of the inverter circuit to a neutral wire; or, the bridge arm midpoint of one phase at the AC side of the inverter circuit is connected to a positive electrode of the DC bus, and the relationship is that the positive half-bus voltage is equal to an absolute value of a sum of the neutral-to-ground voltage at the AC side and a voltage of the phase at the AC side to a neutral wire.

In an embodiment, the half-bus acquisition voltage is a negative half-bus voltage. The bridge arm midpoint of one phase at the AC side of the inverter circuit is connected to a negative electrode of the DC bus, and the relationship is that the negative half-bus voltage is equal to an absolute value of a sum of the neutral-to-ground voltage at the AC side and a voltage of the phase at the AC side of the inverter circuit to a neutral wire; or, the bridge arm midpoint of one phase at the AC side of the inverter circuit is connected to a positive electrode of the DC bus, and the relationship is that a difference obtained by subtracting the negative half-bus voltage from a DC bus voltage is equal to an absolute value of a sum of the neutral-to-ground voltage at the AC side and a voltage of the phase at the AC side to a neutral wire.

In an embodiment, before the calculating the half-bus acquisition voltage before and after the controllable switch is turned on based on a sampled value of the neutral-to-ground voltage at the AC side and the relationship to obtain calculated values, the insulation impedance detection method further includes: determining whether a sampled value of the half-bus acquisition voltage before the controllable switch is turned on is less than a preset value; going, in response to the sampled value of the half-bus acquisition voltage being less than the preset value, to the process of calculating the half-bus acquisition voltage before and after the controllable switch is turned on based on a sampled value of the neutral-to-ground voltage at the AC side and the relationship to obtain calculated values; and calculating, in response to the sampled value of the half-bus acquisition voltage being greater than or equal to the preset value, the insulation impedance at the DC side of the inverter to the ground based on the sampled value of the half-bus acquisition voltage, the equivalent impedance of the DC bus to the ground before the controllable switch is turned on and the equivalent impedance of the DC bus to the ground after the controllable switch is turned on.

In an embodiment, before the calculating an insulation impedance at the DC side of the inverter to ground, the insulation impedance detection method further includes: determining a grid-connected/off-grid state of the inverter; and determining, based on the grid-connected/off-grid state of the inverter, the equivalent impedance of the DC bus to the ground before the controllable switch is turned on and the equivalent impedance of the DC bus to the ground after the controllable switch is turned on.

In an embodiment, the determining a grid-connected/off-grid state of the inverter includes: determining whether a voltage at a grid-connected port of the inverter is within a preset grid voltage range; determining that the inverter is in a grid-connected state in response to the voltage at the grid-connected port of the inverter being within the preset grid voltage range; and determining that the inverter is in an off-grid state in response to the voltage at the grid-connected port of the inverter being not within the preset grid voltage range.

In an embodiment, after the calculating an insulation impedance at the DC side of the inverter to ground, the insulation impedance detection method further includes: disconnecting the bridge arm midpoint of the phase at the AC side of the inverter circuit from the electrode of the DC bus.

In a second aspect, an inverter is provided according to the present disclosure. The inverter includes: an inverter circuit, a Y-type resistive bridge, a detection unit and a controller. A direct-current, DC, side of the inverter circuit is connected to a DC bus. The DC bus is grounded through the Y-type resistive bridge. A controllable switch is connected between one electrode of the DC bus and a midpoint of the Y-type resistive bridge. An alternating-current, AC, side of the inverter circuit is connected to a grid-connected port of the inverter through a filtering unit, an inverter relay, a grid-connected relay, an AC electromagnetic interference, EMI, filtering unit and an AC lightning protection unit. The inverter circuit is controlled by the controller. The detection unit is configured to sample a voltage of one electrode of the DC bus to ground as a half-bus acquisition voltage of the DC bus, sample a neutral-to-ground voltage at the AC side of the inverter circuit and a voltage at the grid-connected port of the inverter, and transmit, to the controller, the sampled voltage of the electrode of the DC bus to ground, the sampled neutral-to-ground voltage and the sampled voltage at the grid-connected port. The controller is configured to perform the insulation impedance detection method for the inverter according to any method described in the first aspect.

In an embodiment, the inverter circuit is implemented by an H-bridge topology, a three-level topology, a Heric topology, an H6 topology, or a three-phase full-bridge topology.

In an embodiment, the controllable switch is connected between a positive electrode of the DC bus and a midpoint of the Y-type resistive bridge.

In an embodiment, the inverter further includes at least one DC/DC conversion circuit, where a side of the at least one DC/DC conversion circuit is connected to a corresponding DC power supply, and another side of the at least one DC/DC conversion circuit is connected to the DC bus.

With the insulation impedance detection method for the inverter according to the present disclosure, a bridge arm midpoint of one phase at an AC side of an inverter circuit in the inverter is connected to one electrode of the DC bus, and a relationship between a neutral-to-ground voltage at the AC side of the inverter circuit and a half-bus acquisition voltage of the DC bus is determined under a present connection condition; the half-bus acquisition voltage before and after the controllable switch is turned on are calculated based on a sampled value of the neutral-to-ground voltage at the AC side and the relationship to obtain calculated values; and an insulation impedance at the DC side of the inverter to ground is calculated based on the calculated values of the half-bus acquisition voltage instead of the sampled value of the half-bus acquisition voltage, in combination with an equivalent impedances of the DC bus to the ground before and after the controllable switch is turned on. Furthermore, in a case that the voltage of the positive electrode of the DC bus to the ground is relatively low in the conventional technology, a calculated value of the voltage of the positive electrode of the DC bus to the ground is calculated based on the sampled value of the neutral-to-ground voltage at the AC side and the relationship, instead of calculating the insulation impedance with a relatively small sampled voltage of the positive electrode of the DC bus to the ground, thereby avoiding a low detection precision of the insulation impedance due to the small sampled voltage.

## BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. Apparently, the drawings in the following description show only some embodiments of the present disclosure, and other drawings may be obtained by those skilled in the art from the drawings without any creative work.

FIG. 1 is a schematic structural diagram of an inverter according to an embodiment of the present disclosure;

FIG. 2 is a schematic structural diagram of a DC/DC conversion circuit in an inverter according to an embodiment of the present disclosure;

FIG. 3 is a schematic structural diagram of a DC/DC conversion circuit in an inverter according to another embodiment of the present disclosure;

FIG. 4 is an equivalent structural diagram of the structure shown in FIG. 2 during an insulation impedance detection process;

FIG. 5 is an equivalent structural diagram of the structure shown in FIG. 3 during an insulation impedance detection process;

FIG. 6 is a schematic structural diagram of an equivalent delta circuit at a DC side of an inverter in the structure shown in FIG. 2;

FIG. 7 is a schematic structural diagram of an equivalent delta circuit at a DC side of an inverter in the structure shown in FIG. 3;

FIG. 8 is a flowchart of an insulation impedance detection method for an inverter according to an embodiment of the present disclosure;

FIG. 9 is a schematic structural diagram of an inverter circuit in an inverter according to an embodiment of the present disclosure;

FIG. 10 is a schematic structural diagram of an inverter circuit in an inverter according to another embodiment of the present disclosure;

FIG. 11 is a schematic structural diagram of detecting a voltage of a neutral wire N at an AC side of an inverter to a ground wire PE according to an embodiment of the present disclosure;

FIG. 12 is a simplified diagram illustrating an overall impedance of an inverter in an grid-connected state and an off-grid state according to an embodiment of the present disclosure;

FIG. 13 is a flowchart of an insulation impedance detection method for an inverter according to another embodiment of the present disclosure;

FIG. 14 is a schematic structural diagram of an inverter according to an embodiment of the present disclosure; and

FIG. 15 is a schematic structural diagram of an inverter according to another embodiment of the present disclosure.

## DETAILED DESCRIPTION

Technical solutions of embodiments of the present disclosure are clearly and completely described hereinafter in conjunction with the drawings of the embodiments of the present disclosure. Apparently, the embodiments described are only some embodiments of the present disclosure, rather than all embodiments. Any other embodiments obtained by those skilled in the art based on the embodiments in the present disclosure without any creative work fall within the protection scope of the present disclosure.

The terms "include", "comprise" or any other variants thereof are intended to be nonexclusive. Therefore, a process, method, article or device including a series of elements include not only these elements but also other elements that are not clearly enumerated, or further include elements inherent in the process, method, article or device. Unless expressively limited, the statement "including a..." does not exclude the case that other similar elements may exist in the process, method, article or device including the series of elements.

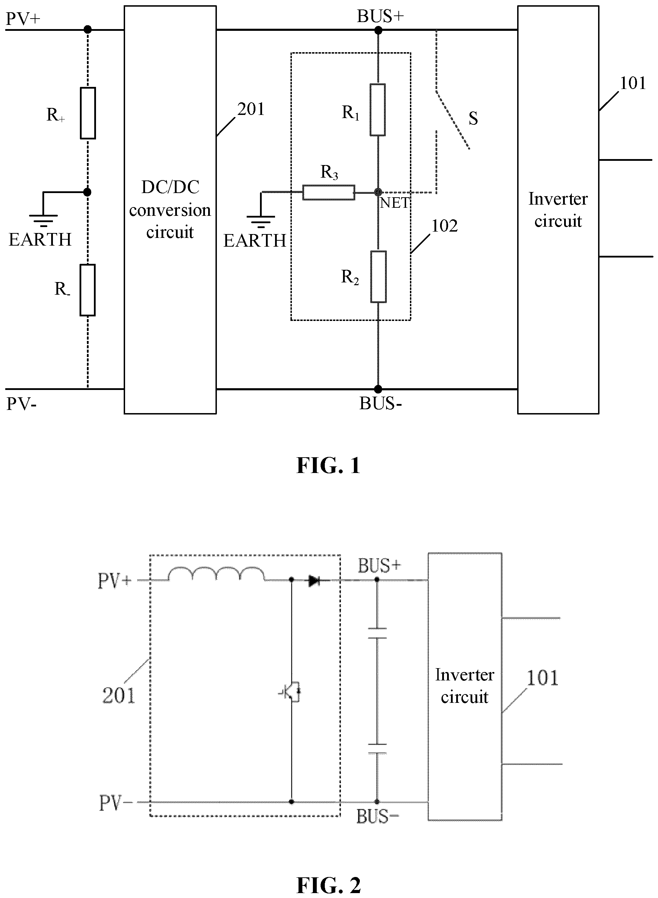

FIG. 1 exemplarily illustrates a structure of an inverter, a DC bus (having a positive electrode BUS+ and a negative electrode BUS-) of the inverter is grounded EARTH through a Y-type resistive bridge 102, and a controllable switch S is connected between an electrode (for example, the positive electrode BUS+ as shown in FIG. 1) of the DC bus and a midpoint NET of the Y-type resistive bridge 102.

As shown in FIG. 1, the Y-type resistive bridge 102 includes three resistor strings represented by $R_1$ to $R_3$, respectively. The resistor string $R_1$ is connected between the positive electrode BUS+ of the DC bus and the midpoint NET, the resistor string $R_2$ is connected between the negative electrode BUS- of the DC bus and the midpoint NET, and the resistor string $R_3$ is connected between the midpoint NET and the ground EARTH.

In addition, as shown in FIG. 1, R+ represents an insulation resistance of a positive electrode PV+ at a DC side of the inverter to the ground, and R_ represents an insulation resistance of a negative electrode PV- at the DC side of the inverter to the ground. A rear stage of the DC bus is connected to an inverter circuit 101, and a front stage of the DC bus is connected to a corresponding photovoltaic string (having the positive electrode PV+ and the negative electrode PV-) through at least one DC/DC conversion circuit 201 (for example, one DC/DC conversion circuit 201 is shown in FIG. 1).

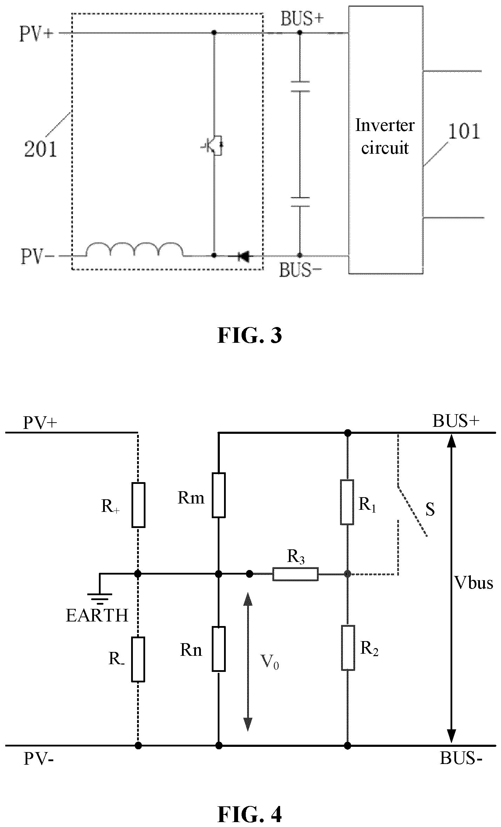

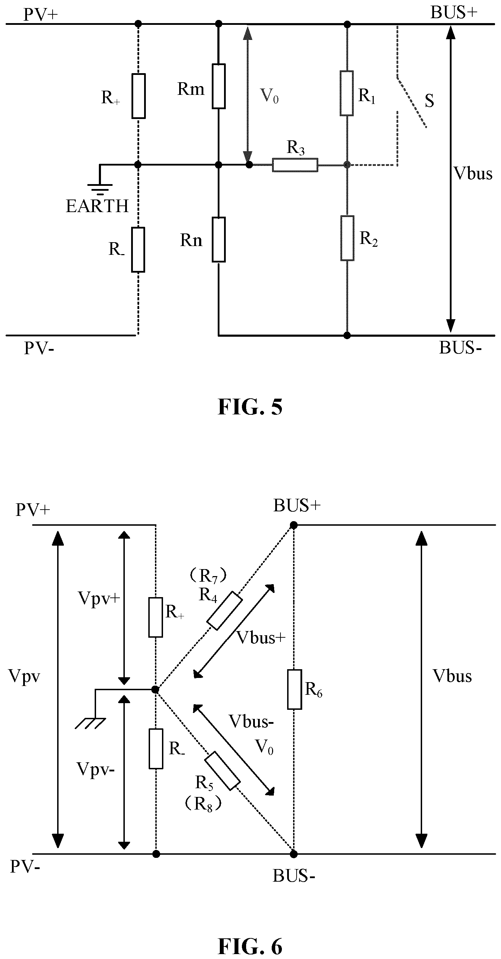

In a case that the DC/DC conversion circuit 201 in FIG. 1 is a Boost circuit (as shown in FIG. 2), both a diode and an inductor are arranged in a positive transmission branch, and the negative electrode PV- at the DC side of the inverter is directly connected to the negative electrode BUS- of the DC bus. In this case, an equivalent structure is shown in FIG. 4. In a case that the DC/DC conversion circuit 201 in FIG. 1 is implemented by a mirror structure (as shown in FIG. 3) of the Boost circuit, both a diode and an inductor are arranged in a negative transmission branch, and the positive electrode PV+ at the DC side of the inverter is directly connected to the positive electrode BUS+ of the DC bus. In this case, an equivalent structure is shown in FIG. 5. In FIG. 4 and FIG. 5, Rm represents an equivalent resistor between the positive electrode BUS+ of the DC bus and the ground EARTH, and Rn represents an equivalent resistor between the negative electrode BUS- of the DC bus and the ground EARTH. $V_{bus}$ represents a bus voltage. $V_0$ represents a half of the bus voltage that is sampled, which may be referred to as a half-bus acquisition voltage. In FIG. 4, the half-bus acquisition voltage is a negative half-bus voltage. In FIG. 5, the half-bus acquisition voltage is a positive half-bus voltage.

In practice, for acquiring the DC bus voltage, only two of the bus voltage, the positive half-bus voltage and the negative half-bus voltage are sampled, and then the other voltage is calculated. In an embodiment, the bus voltage and the positive half-bus voltage are sampled, and the negative half-bus voltage is calculated through subtraction. In an embodiment, the bus voltage and the negative half-bus voltage are sampled, and the positive half-bus voltage is calculated through subtraction. In an embodiment, the positive half-bus voltage and the negative half-bus voltage are sampled, and the bus voltage is calculated through addition. For the case shown in FIG. 4, since the negative electrode PV- at the DC side of the inverter is directly connected to the negative electrode BUS- of the DC bus, voltages of the negative electrode PV- and the negative electrode BUS- to the ground are equal to each other. Therefore, in an embodiment, the bus voltage and the negative half-bus voltage are sampled, that is, the negative half-bus voltage serves as the half-bus acquisition voltage $V_0$. In an embodiment, for the case shown in FIG. 5, the bus voltage and the positive half-bus voltage are sampled, that is, the positive half-bus voltage serves as the half-bus acquisition voltage $V_0$.

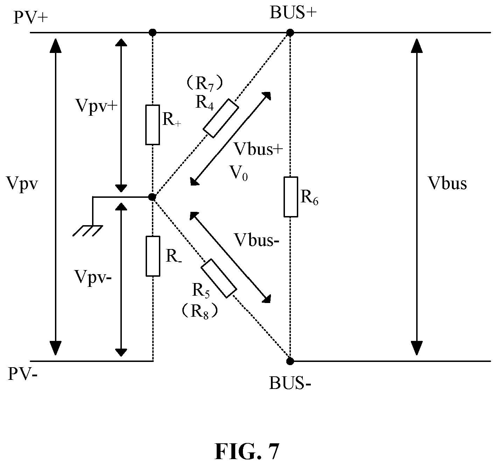

The controllable switch S is turned on or off, and the insulation impedance at the DC side of the inverter to the ground is calculated based on the sampled voltages of the DC bus at different on-off conditions of the controllable switch. In order to facilitate calculation, the Y-type circuit shown in FIG. 4 is equivalently simplified as a delta-type circuit shown in FIG. 6, and the Y-type circuit shown in FIG. 5 is equivalently simplified as a delta-type circuit shown in FIG. 7. In FIG. 6 and FIG. 7, $R_4$ represents an equivalent resistance of the positive electrode BUS+ of the DC bus to the ground EARTH in a case that the controllable switch S is turned off, $R_5$ represents an equivalent resistance of the negative electrode BUS- of the DC bus to the ground EARTH in a case that the controllable switch S is turned off, $R_6$ represents an equivalent resistance of the positive electrode BUS+ of the DC bus to the negative electrode BUS- of the DC bus, $R_7$ represents an equivalent resistance of the positive electrode BUS+ of the DC bus to the ground EARTH in a case that the controllable switch S is turned on, and $R_8$ represents an equivalent resistance of the negative electrode BUS- of the DC bus to the ground EARTH in a case that the controllable switch S is turned on. $V_{pv}$ represents a voltage of the photovoltaic string connected to the DC side of the inverter. $V_{pv+}$ represents a voltage of the positive electrode of the photovoltaic string to the ground EARTH. $V_{pv-}$ represents a voltage of the negative electrode of the photovoltaic string to the ground EARTH. $V_{bus+}$ represents the positive half-bus voltage, that is, a voltage of the positive electrode BUS+ of the DC bus to the ground EARTH. $V_{bus-}$ represents the negative half-bus voltage, that is, a voltage of the negative electrode BUS- of the DC bus to the ground EARTH. After the controllable switch S is turned on, the resistor string $R_1$ in the Y-type resistive bridge 102 is bypassed, and the resistor string $R_2$ becomes the resistor between the positive electrode BUS+ and the negative electrode BUS- of the DC bus. Therefore, in combination with FIG. 4 and FIG. 6, or in combination with FIG. 5 and FIG. 7, the following equation is obtained as:

$$\begin{cases} R_4 = (R_1 + R_3 + \dfrac{R_1 \cdot R_3}{R_2}) \ //R_m \\ R_5 = (R_2 + R_3 + \dfrac{R_2 \cdot R_3}{R_1}) \ //R_n \\ R_7 = R_3 //R_m \\ R_8 = R_n \end{cases} \qquad (1)$$

For FIG. 6 and FIG. 7, according to Kirchhoff's Current Law (KCL), before the controllable switch S is turned on, the following equation is obtained as:

$$\frac{V_{pv-}}{R_-} - \frac{V_{pv+}}{R_+} + \frac{V_{bus-}}{R_5} - \frac{V_{bus+}}{R_4} = 0 \qquad (2)$$

After the controllable switch S is turned on, the following equation is obtained as:

$$\frac{V'_{pv-}}{R_-} - \frac{V'_{pv+}}{R_+} + \frac{V'_{bus-}}{R_8} - \frac{V'_{bus+}}{R_7} = 0 \qquad (3)$$

Where, V'pv+ represents a voltage of the positive electrode of the photovoltaic string to the ground EARTH after the controllable switch S is turned on, $V'_{pv-}$ represents a voltage of the negative electrode of the photovoltaic string to the ground EARTH after the controllable switch S is turned on, $V'_{bus+}$ represents the positive half-bus voltage after the controllable switch S is turned on, and $V'_{bus-}$ represents the negative half-bus voltage after the controllable switch S is turned on.

By subtracting the equation (2) from the equation (3), the following equation is obtained as:

$$\frac{R_+ \cdot \left(V'_{pv-} - V_{pv-}\right) + R_- \cdot \left(V_{pv+} - V'_{pv+}\right)}{R_+ \cdot R_-} = \frac{V'_{bus+}}{R_7} - \frac{V_{bus+}}{R_4} + \frac{V_{bus-}}{R_5} - \frac{V'_{bus-}}{R_8} \qquad (4)$$

In FIG. 6, $V_{pv-}=V_{bus-}=V_0$, $V'_{pv-}=V'_{bus-}=V'_0$, where $V'_0$ represents the half-bus acquisition voltage after the controllable switch S is turned on. Therefore, in the equation (4), $V'_{pv-}-V_{pv-}=V'_0-V_0$. In addition, in FIG. 6, $V_{pv+}=V_{pv}-V_{pv-}=V_{pv}-V_0$, $V'_{pv+}=V'_{pv}-V'_{pv-}=V'_{pv}-V'_0$, where $V'_{pv}$ represents the voltage of the photovoltaic string after the controllable switch S is turned on. Since the voltage between the positive electrode and the negative electrode of the photovoltaic string is unchanged before and after the controllable switch S is turned on, that is, $V_{pv}=V'_{pv}$, and thus $V_{pv+}=V_{pv}-V_0$, $V'_{pv+}=V_{pv}-V'_0$. Therefore, in the equation (4), $V_{pv+}-V'_{pv+}=V_{pv}-V_0-(V_{pv}-V'_0)=V'_0-V_0$. In addition, $V_{bus-}=V_0$ and $V'_{bus-}=V'_0$, and thus $V_{bus+}=V_{bus}-V_{bus-}=V_{bus}-V_0$, $V'_{bus+}=V'_{bus}-V'_{bus-}=V'_{bus}-V'_0$. In this condition, by simplifying the equation (4), the equation (5) is obtained as:

$$\frac{R_+ \cdot R_-}{R_+ + R_-} = \frac{V'_0 - V_0}{\dfrac{V'_{bus} - V'_0}{R_7} - \dfrac{V_{bus} - V_0}{R_4} + \dfrac{V_0}{R_5} - \dfrac{V'_0}{R_8}} \qquad (5)$$

In FIG. 7, $V_{pv+}=V_{bus+}=V_0$, $V'_{pv+}=V'_{bus+}=V'_0$, where $V'_0$ represents the half-bus acquisition voltage after the controllable switch S is turned on. Therefore, in the equation (4), $V_{pv+}-V'_{pv+}=V_0-V'_0$. In addition, in FIG. 7, $V_{pv-}=V_{pv}-V_{pv+}=V_{pv}-V_0$, $V'_{pv-}=V'_{pv}-V'_{pv+}=V'_{pv}-V'_0$, where, $V'_{pv}$ represents the voltage between the positive electrode and the negative electrode of the photovoltaic string after the controllable switch is turned on. Since the voltage between the positive electrode and the negative electrode of the photovoltaic string is unchanged before and after the controllable switch S is turned on, that is, $V_{pv}=V'_{pv}$, then $V_{pv-}=V_{pv}-V_0$, $V'_{pv-}=V_{pv}-V'_0$. Therefore, in the equation (4), $V'_{pv-}-V_{pv-}=V_{pv}-V'_0-(V_{pv}-V_0)=V_0-V'_0$. In addition, since $V_{bus+}=V_0$, $V'_{bus+}=V'_0$, then $V_{bus-}=V_{bus}-V_{bus+}=V_{bus}-V_0$, $V'_{bus-}=V'_{bus}-V'_{bus+}=V'_{bus}-V'_0$. In this condition, by simplifying the equation (4), the equation (6) is obtained as:

$$\frac{R_+ \cdot R_-}{R_+ + R_-} = \frac{V_0 - V_0'}{\dfrac{V_0'}{R_7} - \dfrac{V_0}{R_4} + \dfrac{V_{bus} - V_0}{R_5} - \dfrac{V_{bus}' - V_0'}{R_8}} \qquad (6)$$

An equivalent impedance between the positive electrode and the negative electrode at the DC side of the inverter to the ground, that is, an equivalent impedance between the positive electrode and the negative electrode of the photovoltaic string connected to the DC side of the inverter to the ground, is defined as $R_{iso}$. $R_{iso}$ is equal to a parallel resistance of the insulation resistance R+ of the positive electrode PV+ at the DC side of the inverter to the ground and the insulation resistance R_ of the negative electrode PV- at the DC side of the inverter to the ground, the following equation is obtained as:

$$R_{iso} = R_+ // R_- = \frac{R_+ \cdot R_-}{R_+ + R_-}$$

Where, // represents a parallel connection.

Therefore, normally, the equivalent impedance $R_{iso}$ is calculated by using the equation (5) for the Boost circuit, and the equivalent impedance $R_{iso}$ is calculated by using the equation (6) for the mirror structure of the Boost circuit.

However, in a case that the half-bus acquisition voltage $V_0$ is relatively low, that is, in a case that the negative half-bus voltage $V_{bus-}$ in FIG. 6 or the positive half-bus voltage $V_{bus+}$ in FIG. 7 is relatively low, the operational amplifier attenuates the half-bus acquisition voltage and transmits the attenuated voltage to analog to digital (AD) for sampling. A small sampled voltage deviates from an actual voltage, resulting in a low detection precision of the insulation impedance, and failing to meet an actual use requirement.

Therefore, an insulation impedance detection method for an inverter is provided according to the present disclosure, to solve the problem of a low detection precision of the insulation impedance due to the relatively low voltage of the positive electrode of the DC bus to the ground.

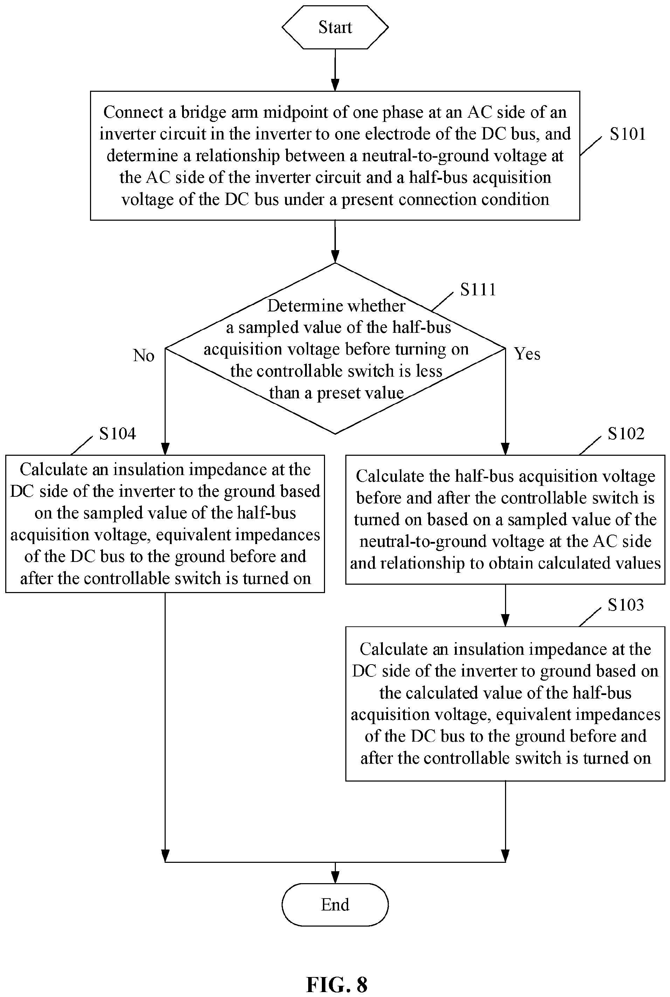

Referring to FIG. 8, the insulation impedance detection method for the inverter includes steps S101 to S103.

In step S101, a bridge arm midpoint of one phase at an AC side of an inverter circuit in the inverter is connected to one electrode of the DC bus, and a relationship between a neutral-to-ground voltage at the AC side of the inverter circuit and a half-bus acquisition voltage of the DC bus is determined under a present connection condition.

In practices, for the bridge arm midpoint of one phase at the AC side of the inverter circuit in the inverter connected to one electrode of the DC bus, the bridge arm midpoint of one phase at the AC side of the inverter circuit in the inverter is connected to the negative electrode of the DC bus, or the bridge arm midpoint of one phase at the AC side of the inverter circuit in the inverter is connected to the positive electrode of the DC bus.

In a case that the inverter circuit is a single-phase inverter circuit, the bridge arm midpoint of one phase at the AC side of the inverter circuit is a live wire at the AC side of the inverter circuit, or a neutral wire at the AC side of the inverter circuit. That is, in this condition, the bridge arm midpoint of one phase at the AC side of the inverter circuit in the inverter is connected to one electrode of the DC bus as follows. The neutral wire at the AC side of the inverter circuit is connected to the negative electrode of the DC bus; the neutral wire at the AC side of the inverter circuit is connected to the positive electrode of the DC bus; the live wire at the AC side of the inverter circuit is connected to the negative electrode of the DC bus; or, the live wire at the AC side of the inverter circuit is connected to the positive electrode of the DC bus.

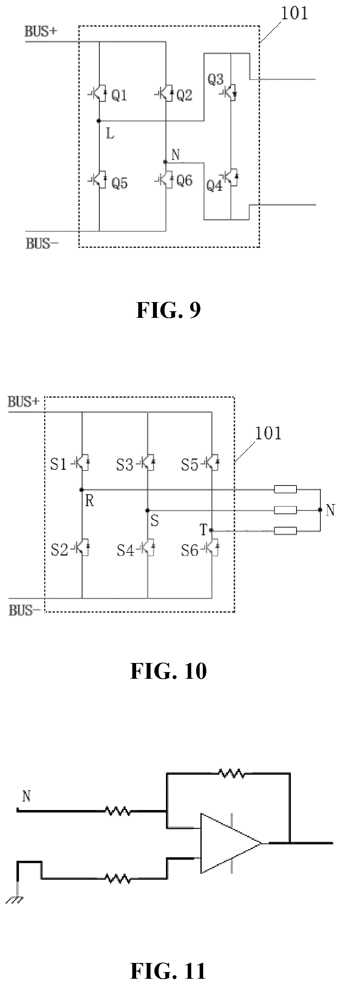

FIG. 9 exemplarily illustrates that the inverter circuit 101 uses a Heric topology to implement a single-phase inverter circuit. During performing insulation impedance detection on the topology structure, one of vertical transistors in the inverter circuit is turned on, so that the bridge arm midpoint of one phase at the AC side of the inverter circuit is connected to one electrode of the DC bus. For example, if an N-phase lower transistor Q6 of the inverter circuit 101 is turned on, the neutral wire N at the AC side is connected to the negative electrode BUS- of the DC bus. If an N-phase upper transistor Q2 of the inverter circuit 101 is turned on, the neutral wire N at the AC side is connected to the positive electrode BUS+ of the DC bus. If an L-phase lower transistor Q5 of the inverter circuit 101 is turned on, the live wire L at the AC side is connected to the negative electrode BUS- of the DC bus. If an L-phase upper transistor Q1 of the inverter circuit 101 is turned on, the live wire L at the AC side is connected to the positive electrode BUS+ of the DC bus.

In a case that the inverter circuit is a three-phase inverter circuit, the bridge arm midpoint of one phase at the AC side of the inverter circuit is an R-phase bridge arm midpoint at the AC side of the inverter circuit, an S-phase bridge arm midpoint at the AC side of the inverter circuit, or a T-phase bridge arm midpoint at the AC side of the inverter circuit. That is, in this condition, the bridge arm midpoint of one phase at the AC side of the inverter circuit in the inverter is connected to one electrode of the DC bus as follows. The R-phase bridge arm midpoint at the AC side of the inverter circuit is connected to the negative electrode of the DC bus; the R-phase bridge arm midpoint at the AC side of the inverter circuit is connected to the positive electrode of the DC bus; the S-phase bridge arm midpoint at the AC side of the inverter circuit is connected to the negative electrode of the DC bus; the S-phase bridge arm midpoint at the AC side of the inverter circuit is connected to the positive electrode of the DC bus; the T-phase bridge arm midpoint at the AC side of the inverter circuit is connected to the negative electrode of the DC bus; or, the T-phase bridge arm midpoint at the AC side of the inverter circuit is connected to the positive electrode of the DC bus.

FIG. 10 exemplarily illustrates that the inverter circuit 101 uses a three-phase full-bridge topology to implement a three-phase inverter circuit. During performing insulation impedance detection on the topology structure, a transistor in any half-bridge arm is turned on, so that the bridge arm midpoint of one phase at the AC side of the inverter circuit is connected to one electrode of the DC bus. For example, if a transistor S2 in an R-phase lower bridge arm of the inverter circuit 101 is turned on, the R-phase bridge arm midpoint at the AC side is connected to the negative electrode BUS- of the DC bus. If a transistor S1 in an R-phase upper bridge arm of the inverter circuit 101 is turned on, the R-phase bridge arm midpoint at the AC side is connected to the positive electrode BUS+ of the DC bus. If a transistor S4 in an S-phase lower bridge arm of the inverter circuit 101 is turned on, the S-phase bridge arm midpoint at the AC side is connected to the negative electrode BUS- of the DC bus. If a transistor S3 in an S-phase upper bridge arm of the inverter circuit 101 is turned on, the S-phase bridge arm midpoint at the AC side is connected to the positive electrode BUS+ of the DC bus. If a transistor S6 in the T-phase lower bridge arm of the inverter circuit 101 is turned on, the T-phase bridge arm midpoint at the AC side is connected to the negative electrode BUS- of the DC bus. If the T-phase upper bridge arm transistor S5 of the inverter circuit 101 is turned on, the T-phase bridge arm midpoint at the AC side is connected to the positive electrode BUS+ of the DC bus.

In a case that the inverter circuit is implemented by other topologies, the bridge arm midpoint of one phase at the AC side of the inverter circuit in the inverter is connected to one electrode of the DC bus by turning on a corresponding transistor, and details are not described herein.

The relationship between a neutral-to-ground voltage $V_{ntope}$ at the AC side of the inverter circuit and the half-bus acquisition voltage $V_0$ of the DC bus depends on the half-bus acquisition voltage $V_0$.

In an embodiment, the half-bus acquisition voltage V0 is the positive half-bus voltage in the following two situations.

In a first situation, the bridge arm midpoint of one phase at the AC side of the inverter circuit in the inverter is connected to the negative electrode of the DC bus, and the relationship is that a difference obtained by subtracting the positive half-bus voltage from the DC bus voltage is equal to an absolute value of a sum of the neutral-to-ground voltage at the AC side and a voltage of the phase at the AC side of the inverter circuit to the neutral wire.

In a case that the negative electrode of the DC bus is connected to the neutral wire (shown as N in FIG. 9 or in FIG. 10) at the AC side of the single-phase inverter circuit, a voltage of this phase at the AC side to the neutral wire is zero. In this case, the relationship is expressed as:

$$\begin{cases} V_0 = V_{bus} - \left| V_{ntope} \right| \\ V_0' = V_{bus}' - \left| V_{ntope}' \right| \end{cases} \qquad (7)$$

In equation (7), parameters in the first line are parameters before the controllable switch S is turned on, and parameters in the second line are parameters after the controllable switch S is turned on, where V'ntope represents a voltage of the neutral wire N at the AC side of the inverter circuit to a ground wire PE after the controllable switch S is turned on.

In a case that the negative electrode of the DC bus is connected to the live wire (shown as L in FIG. 9) at the AC side of the single-phase inverter circuit, the voltage of this phase at the AC side to the neutral wire is a voltage $V_{LN}$ of the live wire L at the AC side of the inverter circuit to the neutral wire N shown in FIG. 9. In this case, the relationship is expressed as:

$$\begin{cases} V_0 = V_{bus} - \left| V_{ntope} + V_{LN} \right| \\ V_0' = V_{bus}' - \left| V_{ntope}' + V_{LN}' \right| \end{cases} \qquad (8)$$

In equation (8), parameters in the first line are parameters before the controllable switch S is turned on, and parameters in the second line are parameters after the controllable switch S is turned on, where $V_{LN}'$ represents a voltage of the live wire L at the AC side of the inverter circuit to the neutral wire N after the controllable switch S is turned on.

In a case that the negative electrode of the DC bus is connected to any phase at the AC side of the single-phase inverter circuit (shown as R, S or T in FIG. 10), a voltage of this phase at the AC side to the neutral wire is described with an example of a phase R at the AC side shown in FIG. 10. That is, a voltage of the R-phase bridge arm midpoint at the AC side of the inverter circuit to the neutral wire N is represented as VRN. In this case, the relationship is expressed as:

$$\begin{cases} V_0 = V_{bus} - \left| V_{ntope} + V_{RN} \right| \\ V_0^{'} = V_{bus}^{'} - \left| V_{ntope}^{'} + V_{RN}^{'} \right| \end{cases} \qquad (9)$$

In equation (9), parameters in the first line are parameters before the controllable switch S is turned on, and parameters in the second line are parameters after the controllable switch S is turned on, where V'RN represents a voltage of the R-phase bridge arm midpoint at the AC side of the inverter circuit to the neutral wire N after the controllable switch S is turned on. The above is similar to the case that the negative electrode of the DC bus is connected to the each of other two phases at the AC side of the single-phase inverter circuit, and details are not described herein again.

In a second situation, the bridge arm midpoint of one phase at the AC side of the inverter circuit is connected to the positive electrode of the DC bus, and the relationship is that the positive half-bus voltage is equal to an absolute value of a sum of the neutral-to-ground voltage at the AC side and a voltage of the phase at the AC side to the neutral wire.

In a case that the positive electrode of the DC bus is connected to the neutral wire (shown as the N in FIG. 9 or in FIG. 10) at the AC side of the single-phase inverter circuit, the voltage of this phase at the AC side to the neutral wire N is zero. In this case, the relationship is expressed as:

$$\begin{cases} V_0 = \left| V_{ntope} \right| \\ V_0^{'} = \left| V_{ntope}^{'} \right| \end{cases} \qquad (10)$$

In equation (10), parameters in the first line are parameters before the controllable switch S is turned on, and parameters in the second line are parameters after the controllable switch S is turned on.

In a case that the positive electrode of the DC bus is connected to the live wire (shown as L in FIG. 9) at the AC side of the single-phase inverter circuit, the voltage of this phase at the AC side to the neutral wire is the voltage VLN of the live wire L at the AC side of the inverter circuit to the neutral wire N shown in FIG. 9. In this case, the relationship is expressed as:

$$\begin{cases} V_0 = \left| V_{ntope} + V_{LN} \right| \\ V_0^{'} = \left| V_{ntope}^{'} + V_{LN}^{'} \right| \end{cases} \qquad (11)$$

In equation (11), parameters in the first line are parameters before the controllable switch S is turned on, and parameters in the second line are parameters after the controllable switch S is turned on.

In a case that the positive electrode of the DC bus is connected to any phase at the AC side of the single-phase inverter circuit (shown as R, S or T in FIG. 10), a voltage of this phase at the AC side to the neutral wire is described with an example of the phase R at the AC side shown in FIG. 10. That is, a voltage of the R-phase bridge arm midpoint at the AC side of the inverter circuit to the neutral wire N is represented as $V_{RN}$. In this case, the relationship is expressed as:

$$\begin{cases} V_0 = \left| V_{ntope} + V_{RN} \right| \\ V_0^{'} = \left| V_{ntope}^{'} + V_{RN}^{'} \right| \end{cases} \qquad (12)$$

In equation (12), parameters in the first line are parameters before the controllable switch S is turned on, and parameters in the second line are parameters after the controllable switch S is turned on. The above is similar to the case that the negative electrode of the DC bus is connected to the each of other two phases at the AC side of the single-phase inverter circuit, and details are not described herein again.

In an embodiment, the half-bus acquisition voltage $V_0$ is the negative half-bus voltage in the following two situations.

In a first situation, the bridge arm midpoint of one phase at the AC side of the inverter circuit in the inverter is connected to the negative electrode of the DC bus, the relationship is that the negative half-bus voltage is equal to an absolute value of a sum of the neutral-to-ground voltage at the AC side and a voltage of the phase at the AC side of the inverter circuit to the neutral wire.

In a case that the negative electrode of the DC bus is connected to the neutral wire (shown as N in FIG. 9 or in FIG. 10) at the AC side of the single-phase inverter circuit, a voltage of this phase at the AC side to the neutral wire N is zero. In this case, the relationship is expressed as the above equation (10).

In a case that the negative electrode of the DC bus is connected to the live wire (shown as L in FIG. 9) at the AC side of the single-phase inverter circuit, the voltage of this phase at the AC side to the neutral wire is the voltage $V_{LN}$ of the live wire at the AC side of the inverter circuit to the neutral wire N shown in FIG. 9. In this case, the relationship is expressed as the above equation (11).

In a case that the negative electrode of the DC bus is connected to any phase at the AC side of the single-phase inverter circuit (shown as R, S or T in FIG. 10), a voltage of this phase at the AC side to the neutral wire is described with an example of the phase R at the AC side shown in FIG. 10. That is, the voltage of the R-phase bridge arm midpoint at the AC side of the inverter circuit to the neutral wire N is represented as $V_{RN}$. In this case, the relationship is expressed as the above equation (12). The above is similar to the case that the negative electrode of the DC bus is connected to each of other two phases at the AC side of the single-phase inverter circuit, and details are not described herein again.

In a second situation, the bridge arm midpoint of one phase at the AC side of the inverter circuit is connected to the positive electrode of the DC bus, the relationship is that a difference obtained by subtracting the negative half-bus voltage from the DC bus voltage is equal to an absolute value of a sum of the neutral-to-ground voltage at the AC side and a voltage of the phase at the AC side to the neutral wire.

In a case that the positive electrode of the DC bus is connected to the neutral wire (shown as N in FIG. 9 or in FIG. 10) at the AC side of the single-phase inverter circuit, the voltage of this phase at the AC side to the neutral wire is zero. In this case, the relationship is expressed as the above equation (7).

In a case that the positive electrode of the DC bus is connected to the live wire (shown as L in FIG. 9) at the AC side of the single-phase inverter circuit, the voltage of this phase at the AC side to the neutral wire is a voltage $V_{LN}$ of the live wire L at the AC side of the inverter circuit to the neutral wire N shown in FIG. 9. In this case, the relationship is expressed as the above equation (8).

In a case that the positive electrode of the DC bus is connected to any phase at the AC side of the single-phase inverter circuit (shown as R, S or T in FIG. 10), a voltage of this phase at the AC side to the neutral wire is described with an example of the phase R at the AC side shown in FIG. 10. That is, the voltage of the R-phase bridge arm midpoint at the AC side of the inverter circuit to the neutral wire N is represented as $V_{RN}$. In this case, the relationship is expressed as the above equation (9). The above is similar to the case that the negative electrode of the DC bus is connected to the each of other two phases at the AC side of the single-phase inverter circuit, and details are not described herein again.

In step S102, the half-bus acquisition voltage before and after the controllable switch is turned on are calculated based on a sampled value of the neutral-to-ground voltage at the AC side and the relationship to obtain calculated values.

Under the present connection condition, a calculated value of the half-bus acquisition voltage (i.e., $V_0$ in the equation) before the controllable switch S is turned on and a calculated value of the half-bus acquisition voltage (i.e., $V'_0$ in the equation) after the controllable switch S is turned on are calculated based on the sampled value of the neutral-to-ground voltage $V_{ntope}$ at the AC side and the relationship by using a corresponding equation of the equation (7) to equation (12).

In step S103, an insulation impedance at the DC side of the inverter to ground is calculated based on the calculated values of the half-bus acquisition voltage, an equivalent impedance of the DC bus to the ground before the controllable switch is turned on and an equivalent impedance of the DC bus to the ground after the controllable switch is turned on.

The insulation impedance $R_{iso}$ at the DC side of the inverter to the ground is calculated by using the equation (5) or equation (6). Where, the equivalent impedances of the DC bus to the ground before and after the controllable switch is turned on are impedances of resistors $R_4$, $R_5$, $R_7$ and $R_8$ in FIG. 6, FIG. 7, and the equation (1).

In the insulation impedance detection method for the inverter according to the embodiment, through the above process, in a case that the half-bus acquisition voltage is relatively low before the controllable switch is turned on, for example, in a case that the voltage of the positive electrode of the DC bus to the ground is relatively low in the conventional technology, a calculated value of the voltage of the positive electrode of the DC bus to the ground is calculated based on the sampled value of the neutral-to-ground voltage at the AC side and the relationship, instead of calculating the insulation impedance with a relatively small sampled voltage of the positive electrode of the DC bus to the ground, thereby avoiding a low detection precision of the insulation impedance due to the small sampled voltage, improving the detection precision of the insulation impedance of the photovoltaic system, and meeting the actual use requirement.

It should be noted that, in practice, only when the sampled value of the half-bus acquisition voltage is small, the calculated value of the half-bus acquisition voltage replaces the sampled value of the half-bus acquisition voltage to calculate the insulation impedance at the DC side to the ground. The sampled value of the half-bus acquisition voltage is still used to calculate the insulation impedance at the DC side to the ground under the normal condition. Therefore, in an embodiment, in the insulation impedance detection method, step S111 is performed before step S102.

In step S111, it is determined whether the sampled value of the half-bus acquisition voltage before the controllable switch is turned on is less than a preset value.

The half-bus acquisition voltage $V_0$ is the negative half-bus voltage shown in FIG. 4, or the positive half-bus voltage shown in FIG. 5. After the half-bus acquisition voltage is sampled, it is determined whether the sampled value is directly used.

In a case that the sampled value of the half-bus acquisition voltage $V_0$ is less than the preset value, the sampled value is not directly used for calculating the insulation impedance, and steps S102 and S103 are performed. In a case that the sampled value of the half-bus acquisition voltage is greater than or equal to the preset value, the sampled value is directly used for calculating the insulation impedance, that is, S 104 is performed.

In step S 104, the insulation impedance at the DC side of the inverter to the ground is calculated based on the sampled value of the half-bus acquisition voltage, the equivalent impedance of the DC bus to the ground before the controllable switch is turned on and the equivalent impedance of the DC bus to the ground after the controllable switch is turned on.

That is, in a case that the sampled value of the half-bus acquisition voltage is relatively small, the sampled value of the half-bus acquisition voltage is directly used for calculating the insulation impedance at the DC side of the inverter to the ground with the equation (5) or (6) in combination with the equation (1), rather than performing the calculation with equations (7) to (12).

That is, during the insulation impedance detection in the self-checking process of the inverter, the bridge arm midpoint of one phase at the AC side of the inverter circuit is connected to one electrode of the DC bus, and it is determined whether the sampled value of the half-bus acquisition voltage is relatively small. If the sampled value of the half-bus acquisition voltage is normal, the insulation impedance is calculated by directly using the sampled value of the half-bus acquisition voltage. If the sampled value of the half-bus acquisition voltage is relatively small, the calculated value of the half-bus acquisition voltage obtained by using the neutral-to-ground voltage at the AC side is instead of the sampled value of the half-bus acquisition voltage, to calculate the insulation impedance.

In addition, regardless of whether the calculated value replaces the sampled value of the half-bus acquisition voltage, after the insulation impedance at the DC side of the inverter to the ground is calculated, the insulation impedance detection method may further include: disconnecting the bridge arm midpoint of the phase at the AC side of the inverter circuit from the electrode of the DC bus. That is, after the insulation impedance detection is performed, the turned-on vertical transistor of the inverter is turned off, so that the inverter circuit can normally operate after the self-checking is performed.

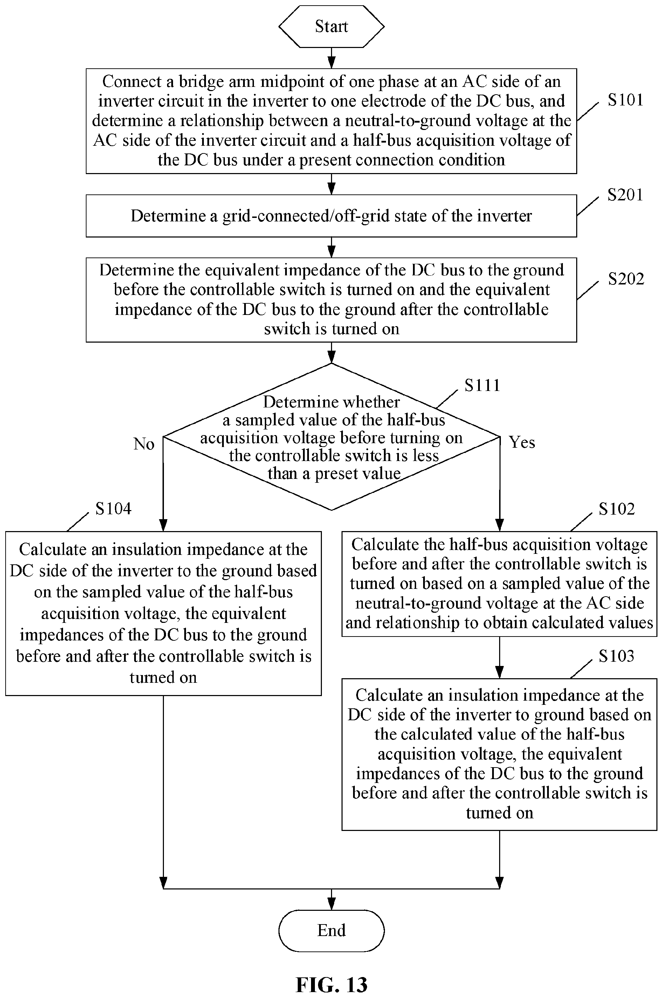

It should be noted that, the insulation resistance of the inverter in the grid-connected state is different from the insulation resistance of the inverter in the off-grid state due to the presence of the sampled voltage of the neutral wire N at the AC side of the inverter circuit to the ground wire PE (as shown in FIG. 11). Therefore, based on the previous embodiment, an insulation impedance detection method is provided according to another embodiment, and further includes steps S201 and 5202 in FIG. 13 before calculating the insulation impedance at the DC side of the inverter to the ground.

In step S201, a grid-connected/off-grid state of the inverter is determined.

The process of S201 may include as follows. It is determined whether a voltage at the grid-connected port of the inverter is within a preset grid voltage range. In a case that the voltage at the grid-connected port is within the preset grid voltage range, it is determined that the inverter is in the grid-connected state, that is, the grid-connected port of the inverter is connected to the power grid. In a case that the voltage at the grid-connected port is not within the preset grid voltage range, it is determined that the inverter is in the off-grid state, that is, the grid-connected port of the inverter is disconnected from the power grid.

After the grid-connected/off-grid state of the inverter is determined, step S202 is performed.

In step S202, the equivalent impedance of the DC bus to the ground before the controllable switch is turned on and the equivalent impedance of the DC bus to the ground after the controllable switch is turned on are determined based on the grid-connected/off-grid state of the inverter.

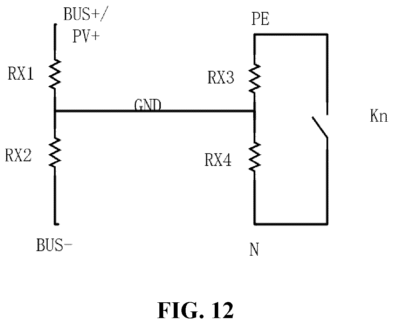

Referring to FIG. 12, RX1 and RX2 are sense resistors for the bus voltage, and a sense resistor for the voltage of the neutral wire N at the AC side to the ground wire PE is RX3 and RX4 connected in series. A switch Kn is turned on to indicate that the inverter is in the grid-connected state, and the switch Kn is turned off to indicate that the inverter is in the off-grid state. It can be seen that under the grid-connected operating condition, the resistors RX3 and RX4 are connected in parallel, and resistance of a reference ground GND to the ground wire PE at the AC side is reduced, so that resistance of the negative electrode BUS- of the DC bus to the ground wire PE at the AC side is reduced, thereby affecting the insulation impedance of the whole system. Therefore, the equivalent impedance, such as $R_4$, $R_5$, $R_7$ or $R_8$ of the DC bus to the ground is different under different operating conditions.

Under the off-grid operating condition, the resistance of the negative electrode BUS- of the DC bus to the ground wire PE at the AC side is Rn in FIG. 4 and FIG. 5, which is equal to resistance of the resistors RX2 and RX3 in series, that is, Rn=RX2+RX3. Under the grid-connected operating condition, Rn=RX2+RX3//RX4. Therefore, Rn in the equation (1) is different in different operating conditions.

In practice, steps S201 and 5202 are not necessarily performed before the step S 111, as long as the steps S201 and 5202 are performed before steps S103 and S104. FIG. 13 is merely an example.

That is, both in the grid-connected state and the off-grid state, the bridge arm midpoint of one phase at the AC side of the inverter circuit is connected to one electrode of the DC bus, and then the sampled value of the half-bus acquisition voltage is determined. If the sampled value is small, the half-bus acquisition voltage are calculated based on the voltage $V_{ntope}$ of the neutral wire N to the ground wire PE at the AC side and the relationship to obtain the calculated values, and the insulation impedance detection is performed. Otherwise, the sampled value of the half-bus acquisition voltage is directly used for insulation impedance detection.

It should be noted that, for the bridge arm midpoint of one phase at the AC side of the inverter circuit connected to an electrode of the DC bus, for example, the N-phase lower transistor Q6 in FIG. 9 is turned on, resistance Rn of the negative electrode BUS- of the DC bus to the ground EARTH is reduced, and Rn=RX2//RX4+RX3. Subsequently, the resistor Rn is used for calculating the equivalent impedance, such as $R_4$, $R_5$, $R_7$ or $R_8$ to the ground in the grid-connected/off-grid state with the equation (5) or equation (6), thus avoiding affecting the accuracy of the final calculation result.

In this embodiment, it is determined whether the inverter is in the grid-connected state or in the off-grid state, to determine different equivalent impedances, so that the detection precision is not affected by external detection conditions.

An inverter is further provided in another embodiment of the present disclosure. As shown in FIG. 1, the inverter includes an inverter circuit 101, a Y-type resistive bridge 102, a detection unit (not shown in FIG. 1) and a controller (not shown in FIG. 1).

A DC side of the inverter circuit 101 is connected to a DC bus (having a positive electrode BUS+ and a negative electrode BUS-). A corresponding bus capacitor (not shown in FIG. 1) is connected between the positive electrode and the negative electrode of the DC bus.

The DC bus is grounded through the Y-type resistive bridge 102. The Y-type resistive bridge 102 includes three resistor strings $R_1$ to $R_3$. A terminal of the resistor string $R_1$ is connected to the positive electrode BUS+ of the DC bus, a terminal of the resistor string $R_2$ is connected to the negative electrode BUS- of the DC bus, and a terminal of the resistor string $R_3$ is grounded EARTH. The other terminals of the three resistor strings are connected to the midpoint NET. The respective structures of the three resistor strings may be referred to the conventional technology, and respective resistance values are not limited, depending on the application environment.

A controllable switch S is connected between one electrode ((for example, the positive electrode BUS+ as shown in FIG. 1) of the DC bus and a midpoint NET of the Y-type resistive bridge 102. The controllable switch S is implemented by a relay, or other devices, depending on the application environment, which is not limited herein.

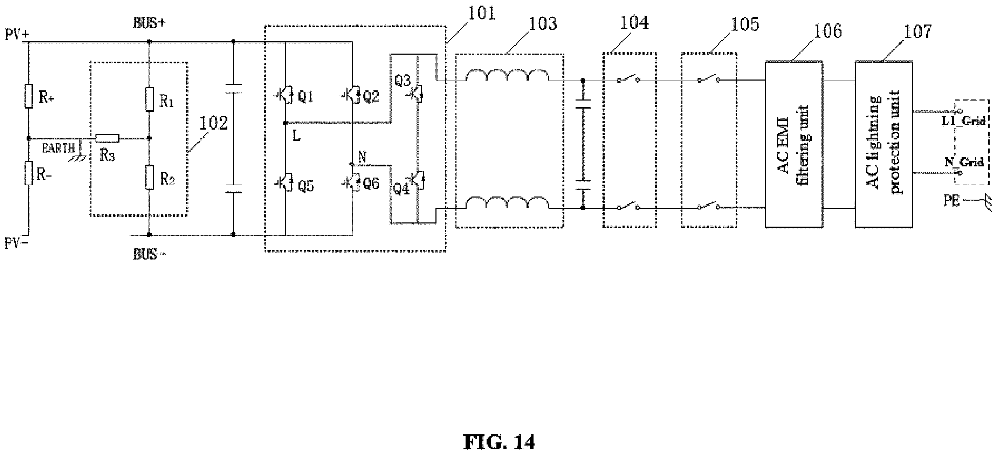

As shown in FIG. 14, an AC side of the inverter circuit 101 is connected to a grid-connected port (shown as L1_Grid and the N_Grid in FIG. 14) of the inverter through a filtering unit 103, an inverter relay 104, a grid-connected relay 105, an AC electromagnetic interference (EMI) filtering unit 106 and an AC lightning protection unit 107 Another side of the grid-connected port is configured to connect a power grid. In addition, a ground wire PE at the AC side of the inverter circuit 101 is grounded EARTH.

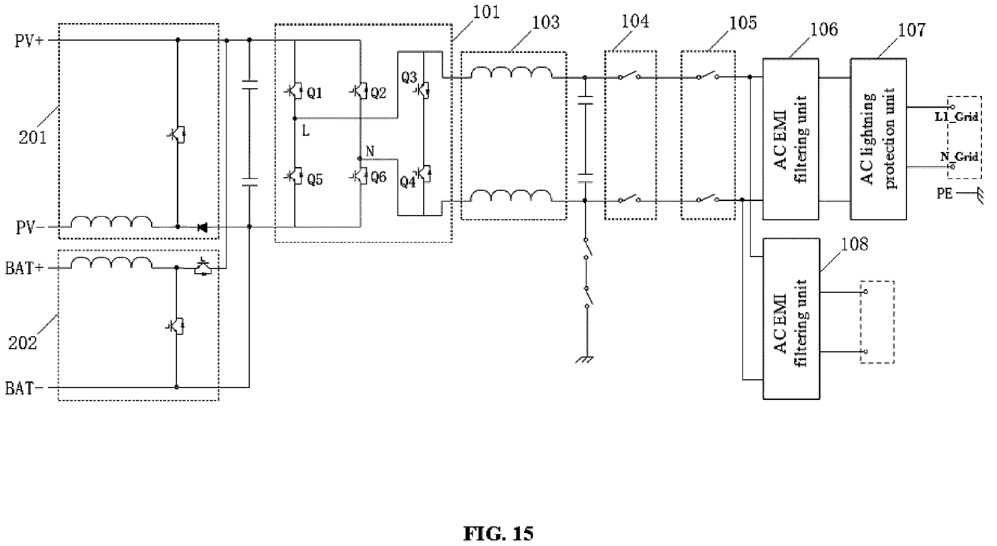

In addition, as shown in FIG. 15, in the inverter, corresponding cables are led out from the inverter relay 104 and the grid-connected relay 105, and another AC EMI filtering unit 108 is arranged to connect an off-grid port of the inverter, so as to connect an electrical apparatus through the off-grid port.

Normally, after the grid-connected port is connected to the power grid, the grid-connected relay 105 is turned on if no abnormality occurs, so that the electrical apparatus connected to the off-grid port can be powered by the power grid if the DC side of the inverter has insufficient power or no power. In this condition, the inverter is in the grid-connected state, and self-checking is performed on the inverter on condition that the inverter relay 104 is turned off. After the grid-connected port is connected to the power grid, the grid-connected relay 105 and the inverter relay 104 are both turned off if the power grid is abnormal, and the inverter is in the off-grid state.

The inverter circuit 101 is controlled by the controller. In addition, the detection unit is configured to sample a voltage of one electrode of the DC bus to ground as a half-bus acquisition voltage of the DC bus, sample a neutral-to-ground voltage at the AC side of the inverter circuit 101 and a voltage at the grid-connected port of the inverter, and transmit, to the controller, the sampled voltage of the electrode of the DC bus to ground, the sampled neutral-to-ground voltage and the sampled voltage at the grid-connected port.

In practice, the inverter circuit 101 may be implemented by the Heric topology shown in FIG. 9, FIG. 14, and FIG. 15, or may be implemented by an H-bridge topology, a three-level topology, an H6 topology or the three-phase full-bridge topology shown in FIG. 10. The topology of the inverter circuit 101 is not limited herein, depending on the application environment. All implementations fall within the protection scope of the present disclosure.

In an embodiment, as shown in FIG. 1, the controllable switch S is connected between the positive electrode BUS+ of the DC bus and the midpoint NET of the Y-type resistive bridge 102. In practice, the controllable switch S may be connected between the negative electrode BUS- of the DC bus and the midpoint NET of the Y-type resistive bridge 102, which is not limited herein. All implementations fall within the protection scope of the present disclosure.

In addition, the inverter is directly connected to a DC power supply through the DC bus. Alternatively, at least one (for example, one DC/DC conversion circuit shown in FIG. 1) DC/DC conversion circuit (shown as 201 in FIG. 1) is arranged in the inverter. A side of the DC/DC conversion circuit is connected to the DC power supply, and another side of the DC/DC conversion circuit is connected to the DC bus. In practice, the DC power supply may be a photovoltaic string or a battery cluster. In an embodiment, as shown in FIG. 15, a photovoltaic string PV and a battery cluster BAT are connected to the DC bus through respective DC/DC conversion circuits (shown as 201 and 202 in FIG. 15). The type of the DC power supply is not limited herein, depending on the application environment. All implementations fall within the protection scope of the present disclosure.

The controller is configured to perform the insulation impedance detection method for the inverter according to any one of the foregoing embodiments. The process and principle of the insulation impedance detection method may be referred to the above embodiments, which are not repeated herein. The controller performs the insulation impedance detection method, improving the detection precision of the insulation impedance, meeting the actual use requirement, and preventing the detection precision from being affected by external detection conditions.

The same or similar parts among the embodiments in this specification may be referred to each other, and each of the embodiments emphasizes differences from other embodiments. In particular, the system or system embodiment is basically similar to the method embodiment, and therefore is described relatively briefly. For relevant details, reference can be made to the corresponding description of the method embodiment. The system and system embodiments described above are only illustrative, in which the units described as separate components may be or may not be physically separated, and the components shown as units may be or may not be physical units, that is, may be located in one place, or distributed over multiple network elements. Some or all of the modules may be selected as needed to achieve the purpose of the solution of the embodiments. Those skilled in the art can understand and implement the solution without any creative effort.

Those skilled in the art may further realize that the units and algorithm steps of each example described in conjunction with the embodiments disclosed herein can be implemented by electronic hardware, computer software, or a combination of both. In order to clearly illustrate the interchangeability of hardware and software, the modules and steps of each example have been described in general terms of functionality in the above description. Whether these functions are performed in hardware or software depends on the specific application and design constraints of the technical solution. Those skilled in the art may implement the described functionality in various manners for each specific application, while such implementations should not be considered to be beyond the scope of the present disclosure.

Based on the above description of the disclosed embodiments, the features described in the different embodiments in this specification may be replaced or combined with each other, so that those skilled in the art can implement or use the present disclosure. Various modifications to these embodiments are apparent by those skilled in the art, and the generic principles defined herein may be implemented in other embodiments without departing from the spirit or scope of the present disclosure. Hence, the present disclosure is not limited to the embodiments disclosed herein, but shall conform to the widest scope in accordance with the principle and novel features disclosed herein.

## Claims

1. An insulation impedance detection method for an inverter, wherein a direct-current, DC, bus of the inverter is grounded through a Y-type resistive bridge, and a controllable switch is connected between one electrode of the DC bus and a midpoint of the Y-type resistive bridge, and the insulation impedance detection method comprises:

   connecting a bridge arm midpoint of one phase at an alternating-current, AC, side of an inverter circuit in the inverter to one electrode of the DC bus, and determining a relationship between a neutral-to-ground voltage at the AC side of the inverter circuit and a half-bus acquisition voltage of the DC bus under a present connection condition;
   calculating the half-bus acquisition voltage before and after the controllable switch is turned on based on a sampled value of the neutral-to-ground voltage at the AC side and the relationship to obtain calculated values; and
   calculating an insulation impedance at the DC side of the inverter to ground based on the calculated values of the half-bus acquisition voltage, an equivalent impedance of the DC bus to the ground before the controllable switch is turned on and an equivalent impedance of the DC bus to the ground after the controllable switch is turned on.

2. The insulation impedance detection method for the inverter according to claim 1, wherein the connecting a bridge arm midpoint of one phase at an AC side of an inverter circuit in the inverter to one electrode of the DC bus comprises one of:

   connecting the bridge arm midpoint of one phase at the AC side of the inverter circuit to a negative electrode of the DC bus; and
   connecting the bridge arm midpoint of one phase at the AC side of the inverter circuit to a positive electrode of the DC bus.

3. The insulation impedance detection method for the inverter according to claim 2, wherein

the inverter circuit is a single-phase inverter circuit, and the bridge arm midpoint of one phase at the AC side of the inverter circuit is a live wire at the AC side of the inverter circuit, or a neutral wire at the AC side of the inverter circuit; or
the inverter circuit is a three-phase inverter circuit, and the bridge arm midpoint of one phase at the AC side of the inverter circuit is an R-phase bridge arm midpoint at the AC side of the inverter circuit, an S-phase bridge arm midpoint at the AC side of the inverter circuit, or a T-phase bridge arm midpoint at the AC side of the inverter circuit.

4. The insulation impedance detection method for the inverter according to claim 1, wherein the half-bus acquisition voltage is a positive half-bus voltage,

the bridge arm midpoint of one phase at the AC side of the inverter circuit is connected to a negative electrode of the DC bus, and the relationship is that a difference obtained by subtracting the positive half-bus voltage from a DC bus voltage is equal to an absolute value of a sum of the neutral-to-ground voltage at the AC side and a voltage of the phase at the AC side of the inverter circuit to a neutral wire; or
the bridge arm midpoint of one phase at the AC side of the inverter circuit is connected to a positive electrode of the DC bus, and the relationship is that the positive half-bus voltage is equal to an absolute value of a sum of the neutral-to-ground voltage at the AC side and a voltage of the phase at the AC side to a neutral wire.

5. The insulation impedance detection method for the inverter according to claim 1, wherein the half-bus acquisition voltage is a negative half-bus voltage,

the bridge arm midpoint of one phase at the AC side of the inverter circuit is connected to a negative electrode of the DC bus, and the relationship is that the negative half-bus voltage is equal to an absolute value of a sum of the neutral-to-ground voltage at the AC side and a voltage of the phase at the AC side of the inverter circuit to a neutral wire; or
the bridge arm midpoint of one phase at the AC side of the inverter circuit is connected to a positive electrode of the DC bus, and the relationship is that a difference obtained by subtracting the negative half-bus voltage from a DC bus voltage is equal to an absolute value of a sum of the neutral-to-ground voltage at the AC side and a voltage of the phase at the AC side to a neutral wire.

6. The insulation impedance detection method for the inverter according to claim 1, wherein before the calculating the half-bus acquisition voltage before and after the controllable switch is turned on based on a sampled value of the neutral-to-ground voltage at the AC side and the relationship to obtain calculated values, the insulation impedance detection method further comprises:

determining whether a sampled value of the half-bus acquisition voltage before the controllable switch is turned on is less than a preset value;
going, in response to the sampled value of the half-bus acquisition voltage being less than the preset value, to the process of calculating the half-bus acquisition voltage before and after the controllable switch is turned on based on a sampled value of the neutral-to-ground voltage at the AC side and the relationship to obtain calculated values; and
calculating, in response to the sampled value of the half-bus acquisition voltage being greater than or equal to the preset value, the insulation impedance at the DC side of the inverter to the ground based on the sampled value of the half-bus acquisition voltage, the equivalent impedance of the DC bus to the ground before the controllable switch is turned on and the equivalent impedance of the DC bus to the ground after the controllable switch is turned on.

7. The insulation impedance detection method for the inverter according to any one of claims 1 to 6, wherein before the calculating an insulation impedance at the DC side of the inverter to ground, the insulation impedance detection method further comprises:

determining a grid-connected/off-grid state of the inverter; and
determining, based on the grid-connected/off-grid state of the inverter, the equivalent impedance of the DC bus to the ground before the controllable switch is turned on and the equivalent impedance of the DC bus to the ground after the controllable switch is turned on.

8. The insulation impedance detection method for the inverter according to claim 7, wherein the determining a grid-connected/off-grid state of the inverter comprises:

determining whether a voltage at a grid-connected port of the inverter is within a preset grid voltage range;
determining that the inverter is in a grid-connected state in response to the voltage at the grid-connected port of the inverter being within the preset grid voltage range; and
determining that the inverter is in an off-grid state in response to the voltage at the grid-connected port of the inverter being not within the preset grid voltage range.

9. The insulation impedance detection method for the inverter according to any one of claims 1 to 6, wherein after the calculating an insulation impedance at the DC side of the inverter to ground, the insulation impedance detection method further comprises:

disconnecting the bridge arm midpoint of the phase at the AC side of the inverter circuit from the electrode of the DC bus.

10. An inverter, comprising:

an inverter circuit;
a Y-type resistive bridge;
a detection unit; and
a controller, wherein
a direct-current, DC, side of the inverter circuit is connected to a DC bus;
the DC bus is grounded through the Y-type resistive bridge;
a controllable switch is connected between one electrode of the DC bus and a midpoint of the Y-type resistive bridge;
an alternating-current, AC, side of the inverter circuit is connected to a grid-connected port of the inverter through a filtering unit, an inverter relay, a grid-connected relay, an AC electromagnetic interference, EMI, filtering unit and an AC lightning protection unit;
the inverter circuit is controlled by the controller;
the detection unit is configured to sample a voltage of one electrode of the DC bus to ground as a half-bus acquisition voltage of the DC bus, sample a neutral-to-ground voltage at the AC side of the inverter circuit and a voltage at the grid-connected port of the inverter, and transmit, to the controller, the sampled voltage of the electrode of the DC bus to ground, the sampled neutral-to-ground voltage and the sampled voltage at the grid-connected port; and
the controller is configured to perform the insulation impedance detection method for the inverter according to any one of claims 1 to 9.

11. The inverter according to claim 10, wherein the inverter circuit is implemented by an H-bridge topology, a three-level topology, a Heric topology, an H6 topology, or a three-phase full-bridge topology.

12. The inverter according to claim 10 or 11, wherein the controllable switch is connected between a positive electrode of the DC bus and the midpoint of the Y-type resistive bridge.

13. The inverter according to claim 10 or 11, further comprising at least one DC/DC conversion circuit, wherein a side of the at least one DC/DC conversion circuit is connected to a corresponding DC power supply, and another side of the at least one DC/DC conversion circuit is connected to the DC bus.

**FIG. 1**

**FIG. 2**

**FIG. 3**

**FIG. 4**

**FIG. 5**

**FIG. 6**

**FIG. 7**

Start

Connect a bridge arm midpoint of one phase at an AC side of an inverter circuit in the inverter to one electrode of the DC bus, and determine a relationship between a neutral-to-ground voltage at the AC side of the inverter circuit and a half-bus acquisition voltage of the DC bus under a present connection condition — S101

Determine whether a sampled value of the half-bus acquisition voltage before turning on the controllable switch is less than a preset value — S111

No

Yes

S104 — Calculate an insulation impedance at the DC side of the inverter to the ground based on the sampled value of the half-bus acquisition voltage, equivalent impedances of the DC bus to the ground before and after the controllable switch is turned on

S102 — Calculate the half-bus acquisition voltage before and after the controllable switch is turned on based on a sampled value of the neutral-to-ground voltage at the AC side and relationship to obtain calculated values

S103 — Calculate an insulation impedance at the DC side of the inverter to ground based on the calculated value of the half-bus acquisition voltage, equivalent impedances of the DC bus to the ground before and after the controllable switch is turned on

End

**FIG. 8**

**FIG. 9**

**FIG. 10**

**FIG. 11**

**FIG. 12**

Start

Connect a bridge arm midpoint of one phase at an AC side of an inverter circuit in the inverter to one electrode of the DC bus, and determine a relationship between a neutral-to-ground voltage at the AC side of the inverter circuit and a half-bus acquisition voltage of the DC bus under a present connection condition — S101

Determine a grid-connected/off-grid state of the inverter — S201

Determine the equivalent impedance of the DC bus to the ground before the controllable switch is turned on and the equivalent impedance of the DC bus to the ground after the controllable switch is turned on — S202

Determine whether a sampled value of the half-bus acquisition voltage before turning on the controllable switch is less than a preset value — S111

No                                                                    Yes

S104

Calculate an insulation impedance at the DC side of the inverter to the ground based on the sampled value of the half-bus acquisition voltage, the equivalent impedances of the DC bus to the ground before and after the controllable switch is turned on

S102

Calculate the half-bus acquisition voltage before and after the controllable switch is turned on based on a sampled value of the neutral-to-ground voltage at the AC side and relationship to obtain calculated values

S103

Calculate an insulation impedance at the DC side of the inverter to ground based on the calculated value of the half-bus acquisition voltage, the equivalent impedances of the DC bus to the ground before and after the controllable switch is turned on

End

**FIG. 13**

FIG. 14

FIG. 15

Europäisches
Patentamt

European
Patent Office

Office européen
des brevets

# EUROPEAN SEARCH REPORT

**Application Number**

EP 25 15 3410

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 116 973 631 A (SUNGROW POWER SUPPLY SHANGHAI CO LTD) 31 October 2023 (2023-10-31) | 1-3,6-13 | INV. G01R27/02 G01R27/18 |
| A | * figures 2, 3, 5, 6 * * paragraph [0057] - paragraph [0059] * * paragraph [0081] - paragraph [0096] * * paragraph [0112] * | 4,5 | G01R31/42 G01R31/52 H02M7/5387 |
| A | CN 116 068 274 A (PINGGAO GROUP CO LTD) 5 May 2023 (2023-05-05) * figures 1, 2 * * paragraph [0004] - paragraph [0028] * * paragraph [0034] - paragraph [0058] * | 1-13 | |
| A | CN 111 929 505 A (AISWEI NEW ENERGY TECH YANGZHONG CO LTD) 13 November 2020 (2020-11-13) * figures 1, 2 * * paragraph [0004] - paragraph [0024] * | 1-13 | |

**TECHNICAL FIELDS SEARCHED (IPC)**

G01R
H02M

The present search report has been drawn up for all claims

| Place of search | Date of completion of the search | Examiner |
|---|---|---|
| Munich | 13 June 2025 | Kleiber, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 3410

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2025

| Patent document cited in search report | | Publication date | Patent family member(s) | Publication date |
|---|---|---|---|---|
| CN 116973631 | A | 31-10-2023 | NONE | |
| CN 116068274 | A | 05-05-2023 | NONE | |
| CN 111929505 | A | 13-11-2020 | NONE | |

EPO FORM P0459

For more details about this annex : see Official Journal of the European Patent Office, No. 12/82